# FASCICULE DE BREVET EUROPEEN

(11) **EP 0 732 635 B1**
(45) Date de publication et mention de la délivrance du brevet: **07.06.2000**
(21) Numéro de dépôt: 96103115.0
(22) Date de dépôt: 01.03.1996
(51) Int. Cl.: G04D 3/00, B23P 15/00

(54) **Procédé de réalisation d'une piéce de micro-mécanique**
Verfahren zur Herstellung eines mikromechanischen Teiles
Process for the manufacture of a micromechanical element

(30) Priorité: 17.03.1995 FR 9503642
(43) Date de publication de la demande: 18.09.1996
(73) Titulaire: C.S.E.M. CENTRE SUISSE D'ELECTRONIQUE ET DE MICROTECHNIQUE SA, 2007 Neuchâtel (CH)
(72) Inventeur: Hänni, Werner, 2034 Peseux (CH); Perret, André, 2206 Les Geneveys-sur-Coffrane (CH)
(74) Mandataire: Moinas, Michel

(56) Documents cités:
- EP-A- 0 413 040
- EP-A- 0 596 455
- EP-A- 0 605 300
- WO-A-93/05401
- US-A- 5 242 711

## Description

La présente invention est relative à la réalisation de pièces de micro-mécanique, c'est-à-dire des pièces dont les interactions au sein d'un assemblage permettent de produire, transmettre et/ou transformer un mouvement, et dont l'une des dimensions, telle que la hauteur ou l'épaisseur, peut être sub-millimétrique. Un exemple typique d'un mécanisme micro-mécanique est le mouvement horloger pour montre-bracelet transformant l'énergie d'un ressort et l'oscillation d'un balancier en un déplacement de plusieurs aiguilles devant un cadran.

Les pièces de micro-mécanique les plus fréquemment utilisées sont usinées dans un matériau métallique, tel que le fer, maillechort, cuivre, laiton, ou autre, et ce par décolletage dans l'extrémité d'une barre, ou par tronçonnage d'un profilé, ou par emboutissage ou poinçonnage d'une plaque, ou par fraisage d'une forme brute. Certaines pièces peuvent également être moulées en matière synthétique thermodurcissable pour autant que leur géométrie se prête à la réalisation d'un moule. L'avantage essentiel de ces techniques est leur faible coût de réalisation de séries de pièces.

Toutefois, les qualités de fonctionnement des mécanismes assemblés à partir de telles pièces, telles que la précision des déplacements ou l'énergie minimum nécessaire pour la mise en mouvement, trouvent leurs limites dans les caractéristiques intrinsèques de ces pièces.

Notamment, la densité du métal de l'ordre de 9 kg/dm³ fait que les pièces issues présentent une inertie de déplacement ou un moment d'inertie de rotation relativement important. De plus, les coefficients de frottement µ métal/métal à sec sont importants (compris entre 0,1 et 0,2) et entraînent des pertes mécaniques notables. Ces pertes peuvent certes être réduites sensiblement si on prévoit une lubrification, l'huile ou la graisse de cette lubrification devant toutefois être régulièrement renouvelée. De plus, certaines surfaces métalliques peuvent s'oxyder avec le temps, ce qui dégrade alors remarquablement leur coefficient de frottement.

De plus, le coefficient de dilatation linéaire α des métaux est également important (de l'ordre de 10 à 20 10⁻⁶) ce qui est préjudiciable pour des pièces dont le comportement dépend de leur dimension, telles qu'un balancier. Enfin, certaines pièces métalliques peuvent acquérir une aimantation permanente sous l'influence d'un champ magnétique fortuit, ce qui peut induire par la suite des couples de forces parasites.

Dans un mouvement mécanique horloger, chaque facteur mentionné précédemment peut ainsi avoir une répercussion sur la précision finale du mouvement exprimé en minute d'avance ou de retard par mois.

Le but de la présente invention est de réaliser un procédé de réalisation de pièces de micro-mécanique dont les caractéristiques intrinsèques permettent la réalisation de mécanismes particulièrement performants.

Ce but est atteint, selon l'invention, le procédé faisant l'objet de la revendication 1.

De préférence, le premier matériau cristallin de base est du silicium monocristallin ou polycristallin. En alternative, ce matériau peut aussi être de l'oxyde de silicium ou du nitrure de silicium, ou du molybdène, ou du germanium, ou de l'alumine cristallisée, sous forme de rubis ou saphir synthétique, voire fritté.

De préférence, le second matériau de revêtement est du carbone cristallisé sous forme de diamant, dont la surface peut être, si désiré oxygénée, hydrogénée ou fluorée. En alternative, ce matériau peut également être du carbone déposé sous forme de carbone amorphe (DLC), ou un carbure ou nitrure de titane, ou un carbure ou nitrure de silicium, ou un nitrure de bore, sous forme hexagonale ou cubique (C-BN) ou un diborure de titane. Ces divers matériaux peuvent être déposés avec ou sans couche intermédiaire appropriée.

Utilement, les bords supérieur, inférieur et la paroi interne d'un orifice transversal sont métallisés par déposition chimique en phase vapeur afin de permettre une jonction par soudure, brasure, collage avec un axe métallique rapporté, tel que, par exemple, un axe de rotation au centre d'une roue dentée.

En d'autres termes, cet usinage chimique à sec par gaz excité par plasma permet de travailler avec une précision remarquable des pièces en matériau cristallin jusqu'à maintenant jamais envisagée pour des dispositifs de micro-mécanique, alors que certaines qualités intrinsèques : faible densité, faible coefficient de dilatation, amagnétisme etc... peuvent s'avérer fort avantageuses sur les qualités du comportement général du mécanisme.

Avantageusement, une pluralité de pièces de micro-mécanique sont découpées dans une même plaque d'un premier matériau qui, si désiré, est préalablement rapporté sur une plaque de support, également appelée substrat, et ce par des techniques de micro-usinage appliquées à la réalisation de circuits intégrés.

Le procédé permet donc la réalisation d'un lot de pièces de micro-mécanique.

Utilement, l'épaisseur initiale de la plaque du premier matériau cristallin est amincie à une valeur prédéterminée par attaque chimique avant réalisation du premier masque de forme. Utilement encore, on réalise le dépôt d'une ou plusieurs couches de matériau intermédiaire avant le dépôt du second matériau externe de dureté et de coefficient de frottement prédéterminés.

On connaît, certes, des pièces de silicium réalisées en lots sur un substrat par dépôt de couche de matière puis gravure sélective à l'aide de masque selon les techniques appliquées à la réalisation de circuits intégrés. Par exemple, le document FR 2 697 536 décrit la réalisation d'un activateur de table X/Y suspendue dont certaines poutres sont profilées en U avec ou sans ailettes latérales complémentaires. Un autre exemple peut être trouvé dans le document FR 2 697 675 décrivant le procédé de réalisation d'un transducteur capacitif intégré pour microphone. La communication "Micromechanical Polysilicon Shutters and Mirrors for Light Modulator Arrays" faite à la conférence "Eurosensors, Budapest, 26-29 Septembre 1993" décrit la réalisation d'un réseau de miroirs rotatifs, chacun suspendu de chaque côté à une poutre de torsion, ainsi que la réalisation d'un réseau d'obturateurs pour rayon laser, chaque plaque obturateur étant tenue à l'extrémité d'un ressort flexible selon un seul axe horizontal.

Toutefois, à la lecture de ces documents, on se rend compte que ces réalisations ne concernent que des pièces microscopiques, c'est-à-dire d'épaisseur de l'ordre de 1 à 10 µm. Surtout, ces pièces sont systématiquement mises en mouvement par des forces agissant à distance : forces électrostatiques ou électromagnétiques, variation de pression ; et nullement par contact avec une autre pièce. Il est par ailleurs notoirement connu que le silicium est cassant, par exemple en flambage ou en cisaillement, selon certaines orientations de leur plan cristallin. Il n'est donc pas envisageable de pouvoir tailler entièrement une pièce mécanique à partir d'un bloc de silicium avec les méthodes courantes de la micro-mécanique, à savoir perçage, fraisage, limage, et ce librement dans n'importe quel plan. De plus, il est également connu que le silicium s'érode au contact avec d'autres pièces et qu'il possède un coefficient de frottement très important. Chacun de ces facteurs ne pouvait que décourager le mécanicien d'utiliser un tel matériau pour réaliser une pièce afin de l'inclure dans un mécanisme.

Or, dans l'esprit de l'invention, on a d'abord constaté que la majorité des pièces de micro-mécanique rotatives : roue dentée, pignon, ressort spiral, ancre, levier, ont en fait une forme principale contenue dans un plan, lequel plan n'est traversé que par un ou deux axes orthogonaux. De plus, on a constaté que les efforts d'interaction entre les pièces sont plutôt du type "de compression" dès lors que les parties concernées sont suffisamment dimensionnées

Par ailleurs, après de nombreuses études en atelier, on parvient, certes avec de nombreuses difficultés, à rendre l'attaque d'un gaz excité par plasma suffisamment anisotropique pour envisager la découpe pratiquement à la verticale par gravure continue sur une épaisseur d'au moins 1/10ème de millimètre, voire de 4/10ème de millimètre, d'une plaque en matériau cristallin, épaisseur correspondant alors au minimum d'une pièce usuelle de micro-mécanique.

L'invention consiste d'abord à réaliser des pièces en matériau cristallin en des dimensions permettant leur assemblage dans les mécanismes de micro-mécanique usuels tels que mouvement d'horlogerie. L'invention consiste ensuite à rendre ces pièces mécaniquement utilisables en effectuant un recouvrement des parties actives, telles que les dents d'un pignon ou d'une ancre, avec un second matériau dur empêchant premièrement une érosion prématurée de ces parties, mais permettant surtout de modifier très sensiblement le coefficient de frottement. L'invention consiste également à métalliser des orifices borgnes ou traversant dans lesquels sont installés des axes de rotation et de support.

Bien que relativement onéreuse à réaliser, l'utilisation de ces matériaux cristallins s'avère intéressante pour des pièces cruciales d'un mécanisme, par exemple un ressort spiral et son balancier dans un mouvement horloger. En effet, l'usinage s'effectue en des dimensions extrêmement précises. Plus légères, ces pièces présentent des inerties moindres, une insensibilité à la température et aux champs magnétiques naturels.

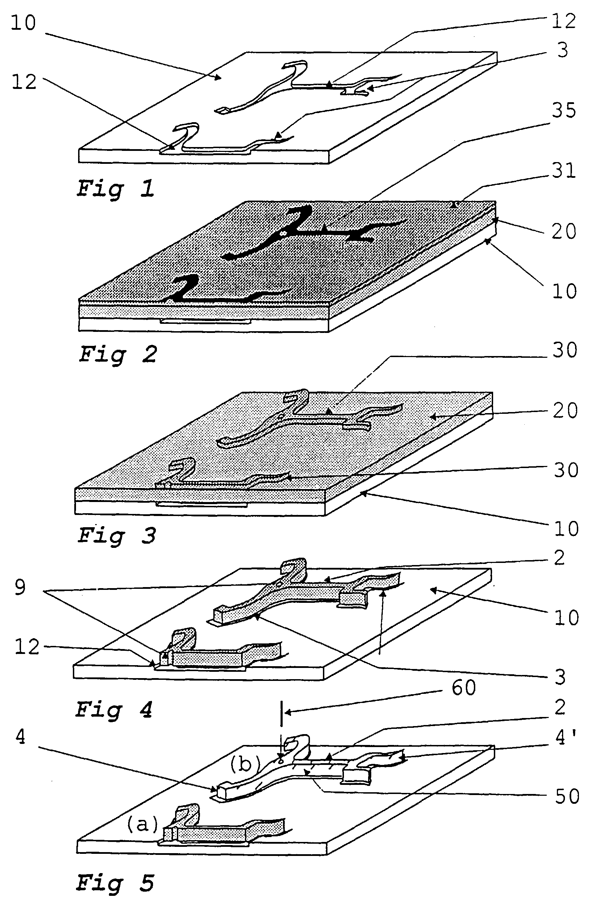

L'invention sera mieux comprise à la lecture de la description qui va suivre d'un mode de réalisation, dont les étapes sont illustrées sous les figures 1 à 5 annexées, et ce pour une ancre de mouvement horloger, étant bien entendu que cette pièce est prise à titre d'exemple nullement limitatif, ce procédé pouvant s'appliquer avec peu de modifications pour d'autres pièces horlogères telles que le ressort-spiral ou le balancier, ou pour toute autre pièce de micro-mécanique essentiellement plane pouvant entrer dans un mécanisme.

Sur la figure 1 est illustrée une plaque de support 10, également appelée substrat, dans laquelle ont été ménagées des cavités 12 par un procédé de structuration lithographique. On notera tout d'abord que, compte-tenu des faibles dimensions d'une telle ancre, le procédé de fabrication selon l'invention s'applique à la fabrication simultanée d'un grand nombre de pièces. Dans cet exemple, on peut ainsi envisager la réalisation de 600 à 700 ancres de 5 mm par 3 mm sur une plaque de support de 4 pouces.

Par structuration lithographique, on entend un procédé permettant le transfert d'une image sur une plaque cristalline, en l'occurrence un substrat en silicium.

Pour ce faire, la plaque 10 est d'abord recouverte d'une couche de laque photosensible. Après un premier recuit, destiné à éliminer une partie des solvants, l'image du masque est transférée dans la laque photosensible par l'exposition de l'ensemble couche-plaque à une lumière ultraviolette. La laque est ensuite développée pour éliminer les parties non exposées, les parties restantes reproduisant le masque étant ensuite durcies par un traitement thermique assisté éventuellement d'une irradiation ultraviolette.

Ensuite, l'opération de gravure consiste à transférer l'image du masque en laque durcie dans la couche cristalline sous-jacente. Cette gravure peut être réalisée par attaque chimique par voie humide dans laquelle le composant chimique agissant sur la couche à usiner provient d'une solution, le résultat de la réaction étant un gaz ou un liquide. On préfère plus fréquemment un usinage sec ou par plasma qui agit soit par érosion physique : bombardement ionique, soit par attaque chimique : l'espèce chimique agissant sur la couche étant un gaz activé, le résultat de la réaction étant un gaz, soit les deux. Ces gravures sont principalement caractérisées par leur vitesse d'attaque, leur directivité et leur sélectivité vis-à-vis des couches sous-jacentes et de masquage. En fonction de ces critères, on retient, pour chaque matériau cristallin à travailler, un procédé, la composition du gaz ou de l'espèce chimique ainsi que les conditions de température et de pression.

En l'occurrence, les cavités 12 sont réalisées par une attaque chimique isotropique avec une solution de d'hydroxyde de potassium KOH. Ces cavités peuvent être rectangulaires ou, comme illustré, reprendre la forme de la future pièce à une échelle quelque peu agrandie, hormis quelques restrictions 3 d'emplacement et de dimensions judicieusement choisis pour constituer, par la suite, des ponts de matière de maintien.

Sur la figure 2 est illustrée comment une plaque 20 en un premier matériau cristallin devant constituer le coeur de l'ancre, ou matériau de base, a été rapportée sur le substrat 10 par soudure autogène. Par exemple, ces deux plaques sont introduites dans un four préchauffé à une température d'environ 1000°C et contenant une atmosphère d'azote, d'oxygène sous une pression atmosphérique.

En fonction des caractéristiques intrinsèques escomptées pour la pièce finale, ce premier matériau cristallin peut être du silicium monocristallin ou polycristallin. En alternative, ce matériau peut aussi être de l'oxyde de silicium ou du nitrure de silicium, quoique les couches réalisables soient minces ; ou du molybdène, ou du germanium, ou de l'alumine cristallisée sous forme de rubis ou saphir synthétique, voire fritté.

Les plaques de silicium usuellement commercialisées présentant une épaisseur de l'ordre de 400 µm, il peut s'avérer nécessaire de l'amincir d'abord à l'épaisseur finale de la pièce, par exemple comprise entre 100 et 200 µm. Pour ce faire, les deux plaques sont disposées dans une solution d'un agent de gravure sélectif à une concentration, à une température et pendant un temps déterminés pour obtenir l'épaisseur voulue.

La plaque de base 20 est ensuite recouverte d'une couche d'oxyde de silicium 31 (SiO₂). Cette couche 31 peut être formée par oxydation thermique dans un four à environ 1100°C et sous une atmosphère oxydante pendant quelques heures. Selon une variante, cette couche 31 peut également être réalisée par dépôt chimique ou physique en phase vapeur (CVD ou PVD). Sur cette couche 31 est rapporté un premier masque 35 en résine insolée puis développé et durci par un procédé lithographique mentionné précédemment. On peut alors graver la couche d'oxyde 31, par exemple à l'aide d'une solution d'acide fluorhydrique (HF) pour obtenir le deuxième masque 30 tel qu'illustré sur la figure 3. L'élimination des parties restantes de la couche de résine photosensible 35 est réalisée de façon classique, par voie humide dans un solvant adéquat ou au moyen d'un plasma sous atmosphère d'oxygène.

La plaque 20 en matériau cristallin devant constituer la base de la pièce est ensuite attaquée sur toute sa profondeur par gravure plasma de manière essentiellement anisotropique, ici à la verticale comme illustré de la figure 3 à la figure 4. Cette anisotropie est importante du fait que cet usinage réalise les faces latérales de l'ancre, et plus particulièrement les deux dents latérales avant 4 appelées à contrôler l'échappement de la roue d'ancre, et la fourche arrière 4' engagée en permanence avec la dent du balancier.

Pour ce faire, l'homme du métier dispose de plusieurs techniques de gravure plasma, notamment la gravure ionique (ion etching) : fraisage essentiellement mécanique par faisceau d'ions (ion beam milling) ou la gravure par érosion (sputter etching) ; ou la gravure dite "plasma" désignant une gravure essentiellement chimique dans laquelle le plasma n'est qu'une source d'un composant réactif qui se combine avec la surface solide pour former un produit volatile ; ou la gravure dite "réactive" : gravure réactive ionique ou par faisceau d'ions (reactive ion etching ou reactive ion beam etching) reposant simultanément sur une réaction chimique pour former un composant volatile et une action physique tel qu'un bombardement d'ions.

Toutefois, selon l'invention, la technique la plus appropriée pour obtenir des flancs droits sur une épaisseur de silicium supérieure à 100 µm est la technique de gravure ionique réactive.

La machine de gravure ionique réactive telle que prévue comprend notamment une enceinte à vide, deux générateurs radio-fréquence RF et un porte-substrat cryogénique assurant des températures de travail de -175°C à +20°C. L'enceinte à vide est pourvue d'un sas de chargement/déchargement divisé en deux sections. La zone supérieure, plus petite, est utilisée pour la génération du plasma. La zone inférieure, à travers laquelle diffusent les espèces actives confinées magnétiquement (type ECR), contient le substrat à graver. Le flux des espèces actives vers la plaquette est contrôlé en variant l'intensité d'un champ magnétique induit par une bobine installée à l'extérieur entre les deux sections de l'enceinte. Le premier générateur RF est responsable de la création du plasma, et l'autre polarise le porte-substrat. La machine est pourvue d'une électronique de commande, d'un groupe de pompage avec pompe turbo-moléculaire et des lignes de gaz idoines. Une vanne asservie permet en outre d'ajuster la pression indépendamment des débits de gaz.

La plaquette de silicium devant être gravée est chargée via le sas et installée sur le porte-substrat cryogénique dans l'enceinte mise ensuite sous vide. Les gaz réactifs sont introduits aux débits voulus dans la partie supérieure de l'enceinte. Après un délai permettant de stabiliser la pression à sa valeur de travail, le premier générateur RF amorce alors le plasma. Des quantités d'espèces chimiquement actives sont ainsi générées et diffusent en direction du substrat à graver. L'énergie des ions incidents est contrôlée au moyen du second générateur RF qui polarise le porte-substrat. Le processus de gravure démarre alors. Les produits de réaction volatiles sont évacués par la ligne de pompage. Lorsque la profondeur est atteinte, les générateurs RF et l'introduction des gaz s'arrêtent, et l'enceinte est vidée. La plaquette gravée est alors déchargée et remise à l'air ambiant via le sas.

Les produits chimiques utilisés sont à base fluorée (O₂ + SF₆). La pression de travail se situe entre 1 et 2 Pa. La température du porte-substrat est ajustée à -100°C. La puissance délivrée par le premier générateur RF de création du plasma est de 1500W. La puissance du second générateur dépend de l'intensité que l'on souhaite donner à l'effet RIE. Le temps de gravure est fonction de la profondeur à graver.

Les cavités 12 formées préalablement dans le substrat 10 ayant un pourtour plus large que celui de l'ancre 2 finalement formée, l'érosion ultime du matériau de base 20 libère la pièce 2 du substrat 10 hormis quelques ponts de matière 3 aisément cassables lorsque désiré. Le résidu d'oxyde du masque 30 apparaissant à la surface supérieure est ensuite éliminé, par attaque chimique et la pièce est nettoyée par voie chimique tel qu'illustré sur la figure 5a.

Une pièce brute de micro-mécanique ainsi obtenue présente déjà, au sein d'un mécanisme, l'avantage d'un faible poids, donc d'une inertie très réduite, et de très faibles coefficients thermique et magnétique.

Par contre, le fait qu'un lot de pièces soit, à ce stade, toujours présent sur un même substrat permet d'envisager, immédiatement à la suite, un ou plusieurs traitements complémentaires simultanément sur toutes ces pièces.

Selon l'invention, un traitement complémentaire consiste à former ou à déposer un revêtement 50 en un second matériau de dureté et de coefficient de frottement prédéterminés, soit de manière générale sur toute la surface de la pièce, soit de manière sélective au moyen de masque sur seulement les parties de la pièce devant interagir avec d'autres pièces, par exemple sur les dents 4 et la fourche 4' de l'ancre 2.

Notamment, pour une pièce et sa contre-pièce, on peut d'abord définir un couple de matériau de revêtement optimisant les critères de tribologie, puis on détermine, selon la nature du matériau de base et/ou la forme de chaque pièce, le mode de dépôt ou de formation du revêtement le plus approprié. Parmi les premiers couples possibles de matériau de revêtement, on peut citer le nitrure de titane contre carbure de titane ou carbure de silicium.

En fait, selon l'invention, on a découvert que le matériau le plus remarquable pour cette application est le carbone déposé chimiquement en phase vapeur sous la forme de diamant, et de préférence sous forme polycristalline pour éviter tout risque de clivage.

Un tel dépôt de carbone cristallisé sous la forme régulière du diamant est en fait possible dès lors que le gaz d'apport, tel qu'un méthane comportant du carbone, est atomisé sous très forte chaleur (et non pas seulement cassé sous forme moléculaire), et que ce carbone atomisé rencontre une surface de condensation plus froide dont la micro-structure est compatible avec sa forme cristalline. Un tel apport de chaleur peut être réalisé soit au sein d'un filament thermique, ou au milieu d'une flamme de combustion dûment réglée, soit par une torche plasma entretenue par micro-ondes ou par émission radio à très haute fréquence, soit par un plasma à micro-ondes ou à micro-ondes magnéto-actives.

Les couples de matériaux de revêtement préférés selon l'invention sont ainsi le diamant contre diamant présentant un coefficient de friction bien inférieur à 0,1 ; ou diamant contre diamant dont la couche externe est complétée de fluor, d'oxygène ou d'hydrogène ; voire diamant contre carbone amorphe, ce dernier matériau étant obtenu avec une température de dépôt plus basse. Dans la pratique, on a constaté que des épaisseurs de revêtement comprises entre 0,1 et 3 µ sont suffisantes pour obtenir l'effet recherché.

Dans le cas particulier de l'ancre 2 illustrée sur la figure 5, la technique de dépôt de diamant la plus appropriée, est soit la méthode par filament thermique, soit une méthode au plasma à micro-ondes.

Dans la méthode par filament thermique (TF-CVD pour Thermal-Filament-Chemical-Vapor-Deposition), un mélange de gaz, typiquement 1% de méthane dans de l'hydrogène, entre en contact sous vide avec un filament chauffé. Sous l'effet de la haute température du filament comprise entre 2000 et 2500°C (correspondant à une lampe à incandescence), l'hydrogène moléculaire se décompose par atomisation. L'hydrogène atomique lui-même réagit en phase gazeuse avec le méthane en formant des radicaux (CH₃, CH₂, CH) et du carbone atomique. Ces gaz réactifs entrent en contact avec un substrat ou une pièce à recouvrir prétraitée (polie) avec de la poudre de diamant, et porté à une température supérieure à 700°C. A la surface de la pièce se forme alors une couche de diamant à partir des sites de nucléation générés par les restes de polissage. Par ce procédé, on obtient des couches de diamant minces (0,1 à 5 µm) cohérentes, adhérentes, uniformes, lisses et d'une morphologie et qualité contrôlable. Le procédé est lent : de 0,2 à 1 µm/h, mais permet le dépôt sur des substrats allant jusqu'à 150 mm de diamètre.

Dans la méthode par torche plasma (RF-ICP-CVD pour Radio-Freqency-Induction-Coupled-Plasma-Torch-CVD), un mélange de gaz, typiquement 1 à 5% de méthane dans de l'hydrogène est "enveloppé" par un gaz facilement ionisable tel que l'argon. Ce mélange est porté à une vitesse proche de la limite du son à travers une bobine d'induction (torche) qui est soumise à une radio-fréquence. Après ionisation du gaz, un plasma à très haute température (supérieure à 4000°C) s'allume. Sa densité et sa forme dépendent de la fréquence appliquée. Cette torche "brûle" sur un substrat ou une pièce initialement préparée par polissage au diamant. La forte chaleur dissipée principalement par la recombinaison de l'hydrogène atomique en hydrogène moléculaire chauffe le substrat. Un refroidissement très intense est nécessaire pour maintenir le substrat à une température stable entre 700 et 1000°C. Une couche de diamant de très haute pureté (pureté dite optique) se dépose à une vitesse de 10 à 100 µm/h. La faible largeur de la torche plasma ne permet pour l'instant pas de revêtir des surfaces plus grandes que 30 à 50 mm de diamètre.

Tel qu'illustré sur la figure 5b, le revêtement est effectué simplement sur toute ou partie de la surface de la pièce. En alternative et selon la pièce à réaliser, le substrat 10 est initialement ajouré 12, au lieu d'être seulement excavé, pour permettre la réalisation de masques puis le revêtement de manière contrôlée sur les faces supérieure et inférieure. En alternative, ce dépôt de revêtement est partiellement réalisé avant la mise en forme des pièces. Ce revêtement est usuellement réalisé sur des pièces encore montées sur leur substrat, mais peut également être effectué sur des pièces déjà isolées.

Ce revêtement de diamant 50 sur des pièces de micro-mécanique en matériau cristallin permet alors de réaliser des mécanismes fonctionnant à sec, c'est-à-dire sans huile, en économisant l'énergie du fait des pertes de frottement très basses, et ne présentant pratiquement pas d'usure.

L'ancre 2, ou toute autre pièce rotative, peut être fixée directement à un axe métallique 60 de rotation au moyen d'une colle araldite, cyanolite ou à base acrylique à choisir selon le matériau cristallin et la nature du métal à assembler.

Toutefois, selon l'invention, un autre traitement complémentaire consiste à métalliser la face interne et/ou les embouchures d'un orifice (9) devant recevoir l'axe métallique de rotation 60, et ce soit avec du molybdène, du tungstène, du chrome ou du titane ou un alliage de métaux adéquat déposé en phase vapeur. En effet, ces métaux forment des carbures qui crochent physiquement et chimiquement au matériau cristallin de base. La fixation de l'axe métallique peut alors être assurée par soudure à température faible : de l'ordre de 100°C, ou à des températures pouvant aller jusqu'à 650°C sous vide ou sous atmosphère contrôlée contenant de l'hydrogène.

On notera que la technique d'usinage décrite précédemment à l'aide de masques de forme et d'attaque à la verticale au moyen d'un plasma anisotrope peut être répétée sur des couches successives dont certaines sont sacrifiées par la suite, et ce pour réaliser d'un seul tenant plusieurs pièces parallèles superposées, par exemple, un ressort spiral relié par un moyeu central directement à son balancier. De nombreuses améliorations peuvent être apportées aux pièces de micro-mécanique et à leur procédé de réalisation dans le cadre des revendications.

## Revendications

1. Procédé de réalisation d'au moins une pièce (2) de micro-mécanique caractérisé en ce qu'il consiste à :
- fixer une plaque (20) d'un premier matériau cristallin à plat sur une plaque de support (10), laquelle plaque de support a préalablement été excavée ou ajourée (12) selon une forme prédéterminée par structuration lithographique,
- réaliser sur la face supérieure de la plaque du premier matériau (20) un premier masque de forme (30) correspondant au pourtour des pièces désirées, par dépôt puis structuration lithographique d'une couche d'un matériau résistant à une attaque plasma,
- découper sur tout le pourtour de chaque masque (30) et dans toute l'épaisseur de la plaque (20) du premier matériau par gravure anisotropique verticale au moyen d'un gaz excité par plasma, chaque pièce (2) n'étant plus retenue à la plaque de support que par un ou plusieurs ponts de matière (3),
- éliminer le premier masque de forme (30),
- déposer par dépôt chimique en phase vapeur une couche (50) d'un second matériau de dureté et de coefficient de frottement prédéterminés soit de manière générale sur toute la surface de la pièce (2), soit de manière sélective au moyen de masque sur seulement les parties de la pièce (2) devant interagir avec d'autres pièces, et
- détacher mécaniquement chaque pièce (2) de la plaque de support (10).

2. Procédé selon la revendication 1, caractérisé en ce que l'épaisseur initiale de la plaque du premier matériau cristallin est amincie à une valeur prédéterminée par attaque chimique avant réalisation du premier masque de forme.

3. Procédé selon la revendication 1, caractérisé en ce que l'on réalise le dépôt d'une ou plusieurs couches de matériau intermédiaire avant le dépôt du second matériau externe de dureté et de coefficient de frottement prédéterminés.

4. Procédé selon la revendication 1, caractérisé en ce que l'on réalise, en outre, une métallisation des parois d'orifices transversaux.

5. Procédé selon la revendication 1, caractérisée en ce que le premier matériau cristallin de base est du silicium monocristallin ou polycristallin, ou son oxyde ou son nitrure.

6. Procédé selon la revendication 1, caractérisée en ce que le premier matériau cristallin de base est du molybdène, du germanium ou l'alumine cristallisée, monocristalline ou frittée sous forme de rubis ou saphir.

7. Procédé selon la revendication 1, caractérisée en ce que le second matériau de revêtement (50) est du carbone cristallisé sous forme de diamant, dont la surface peut être, si désiré, oxygénée, hydrogénée ou fluorée.

8. Procédé selon la revendication 1, caractérisée en ce que le second matériau de revêtement (50) est du carbone amorphe ou du carbure ou nitrure de titane, ou du carbure ou nitrure de silicium, ou du nitrure de bore hexagonal ou cubique.

## Patentansprüche

1. Verfahren zur Herstellung zumindest eines mikromechanischen Teiles (2), dadurch gekennzeichnet, dass es daraus besteht:
- eine Platte (20) eines ersten kristallinen Materials flach auf einer Trägerplatte (10) zu befestigen, wobei diese Trägerplatte vorher durch lithographische Strukturierung gemäss einer vorbestimmten Form ausgehöhlt oder durchbrochen (12) wurde,
- auf der Oberseite der Platte des ersten Materials (20) durch Abscheidung und darauffolgende lithographische Strukturierung einer Schicht aus einem Material, das einem Angriff durch Plasma widersteht, eine erste Formmaske (30) zu realisieren, die den Umrissen der gewünschten Teile entspricht,
- durch anisotropies vertikales Ätzen mit einem plasma-angeregten Gas die Platte (20) des ersten Materials über ihre gesamte Dicke entlang des gesamten Umrisses jeder Maske (30) auszuschneiden, wobei jedes Teil (2) nur noch durch ein oder mehrere Materialbrücken (3) an der Trägerplatte gehalten wird,
- die erste Formmaske (30) zu entfernen,
- durch chemische Abscheidung aus der Dampfphase eine Schicht (50) eines zweiten Materials von vorbestimmter Härte und vorbestimmtem Reibungskoeffizienten abzuscheiden, und zwar entweder generell auf der gesamten Oberfläche des Teils (2) oder selektiv mittels Maske nur auf den Abschnitten des Teils (2), die mit anderen Teilen wechselwirken müssen, und
- jedes Teil (2) mechanisch von der Trägerplatte (10) abzulösen.

2. Verfahren nach Anspruch 1, dadurch gekennzeichnet, dass die anfängliche Dicke der Platte des ersten kristallinen Materials vor Herstellung der ersten Formmaske durch chemischen Angriff auf einen vorbestimmten Wert vermindert wird.

3. Verfahren nach Anspruch 1, dadurch gekennzeichnet, dass man vor der Abscheidung des zweiten äusseren Materials von vorbestimmter Härte und vorbestimmtem Reibungskoeffizienten ein oder mehrere Schichten aus einem Zwischenmaterial abscheidet.

4. Verfahren nach Anspruch 1, dadurch gekennzeichnet, dass man ausserdem eine Metallisierung der Wandungen der durchgehenden Löcher vornimmt.

5. Verfahren nach Anspruch 1, dadurch gekennzeichnet, dass das erste kristalline Basismaterial einkristallines oder polykristallines Silicium oder dessen Oxid oder Nitrid ist.

6. Verfahren nach Anspruch 1, dadurch gekennzeichnet, dass das erste kristalline Basismaterial Molybdän, Germanium oder in Form von Rubin oder Sapphir kristallisiertes monokristallines oder gesintertes Aluminiumoxid ist.

7. Verfahren nach Anspruch 1, dadurch gekennzeichnet, dass das zweite Beschichtungsmaterial (50) in der Form von Diamant kristallierter Kohlenstoff ist, dessen Oberfläche, wenn gewünscht, oxidiert, hydriert oder fluoriert sein kann.

8. Verfahren nach Anspruch 1, dadurch gekennzeichnet, dass das zweite Beschichtungsmaterial amorpher Kohlenstoff oder Titancarbid oder -nitrid, Siliciumcarbid oder -nitrid oder hexagonales oder kubisches Bornitrid ist.

## Claims

1. A method of manufacturing at least one micro-mechanical component, characterized in that it consists in :
- securing a plate (20) of a crystalline first material flat onto a support plate (10), which support plate has previously been excavated or perforated (12) with a predefined shape by lithographic forming;
- providing on the upper face of the plate of first material (20) a first mask (30) whose shape corresponds to the periphery of the desired components by depositing a coating of a material resistant to plasma attack, followed by lithographic forming;
- cutting around the periphery of each mask (30) and through the entire thickness of the plate (20) of first material by anisotropic vertical engraving by means of a plasma-excited gas, whereby each component (2) is retained on the support plate solely by one or several bridges of material (3);
- eliminating the first shaping mask (30);
- depositing by chemical vapor phase deposition a layer (50) of a second material of predetermined hardness and coefficient of friction, either generally over the entire surface of the component (2) or by means of a mask selectively over only those parts of the component (2) that are to interact with other components; and
- mechanically detaching each component (2) from the support plate (10).

2. Method according to claim 1, characterized in that the initial thickness of the plate of crystalline first material is reduced to a predetermined value by etching before applying the first shaping mask.

3. Method according to claim 1, characterized in that one or several intermediate layers of material are deposited before depositing the second external layer of predetermined hardness and coefficient of friction.

4. Method according to claim 1, characterized in that the walls of transverse orifices are also metallized.

5. Method according to claim 1, characterized in that the basic crystalline first material is monocrystalline or polycrystalline silicon or its oxide or nitride.

6. Method according to claim 1, characterized in that the basic crystalline first material is molybdenum, germanium or crystallized alumina, in monocrystalline form or sintered in the form of ruby or saphire.

7. Method according to claim 1, characterized in that the second coating material (50) is crystalline carbon in the form of diamond whose surface may if desired be treated with oxygen, hydrogen or fluorine.

8. Method according to claim 1, characterized in that the second coating material (50) is amorphous carbon or titanium carbide or nitride, or silicon carbide or nitride, or hexagonal or cubic boron nitride.
